# EUROPEAN PATENT SPECIFICATION

(11) **EP 0 462 560 B1**
(45) Date of publication and mention of the grant of the patent: **25.11.1998**
(21) Application number: 91109949.7
(22) Date of filing: 18.06.1991
(51) Int. Cl.: G03F 1/14

(54) **A reticle with phase-shifters and a method of fabricating the same**
Maske mit Phasenschiebern und Verfahren zur Herstellung
Réticule avec décaleurs de phase et méthode de fabrication

(30) Priority: 20.06.1990 JP 163434/90
(43) Date of publication of application: 27.12.1991
(73) Proprietor: FUJITSU LIMITED, Kawasaki-shi, Kanagawa 211 (JP)
(72) Inventor: Nakagawa, Kenji, c/o FUJITSU LIMITED, Kawasaki-shi, Kanagawa 211 (JP)
(74) Representative: Stebbing, Timothy Charles

(56) References cited:
- EP-A- 0 383 534
- EP-A- 0 395 425
- US-A- 3 547 546

## Description

The present invention relates to a reticle used for projecting a very fine pattern on a semiconductor substrate in photolithography, more particularly to a reticle in which phase-shifters are incorporated, and to a method of fabricating a reticle with phase-shifters.

With the trend toward higher integration of integrated circuits, patterns formed on a semiconductor substrate in photolithography are required to be increasingly fine and precise. A reticle incorporating phase-shifters is one means of achieving this.

As is well-known, a magnified pattern with a magnification ratio of about 1 to 10 is formed on a reticle, and the reticle pattern is projected to form a reduced real image on a semiconductor substrate by a step and repeat method using a so-called stepper.

When the dimensions of the pattern on the semiconductor substrate are reduced to a submicron order, there arises a problem that light rays penetrating through two adjacent transparent portions of the reticle pattern, separated by a narrow strip portion, interfere with each other, so that an accurate image of the strip portion is not formed on the semiconductor substrate.

In order to solve the interference problem between adjacent light rays, a phase-shifter technique has recently been introduced into reticle fabrication.

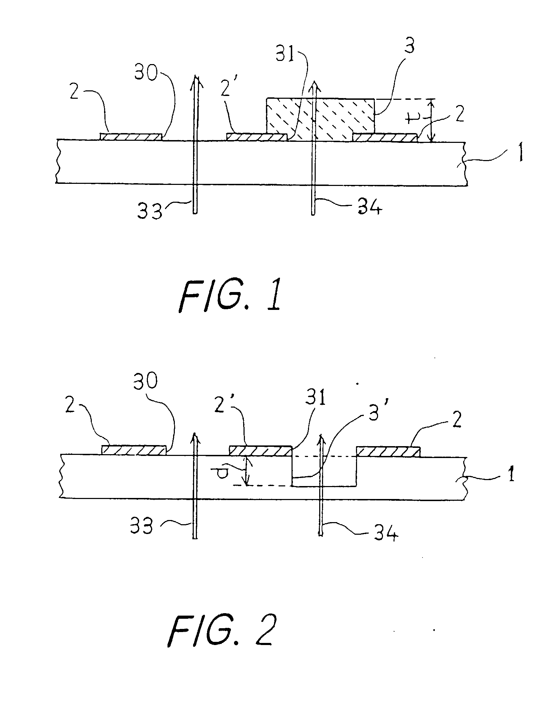

A typical reticle structure having phase-shifters is shown for example in Fig. 1. On a reticle substrate 1 of glass or quartz, a light-shielding layer 2 (hereinafter called a shield layer), generally of chromium (Cr) or a chromium compound, is formed by a conventional method. Of two adjacent openings 30 and 31, one opening 31 between shield layers 2 and 2' is covered with a phase-shift layer 3 (hereinafter called a phase-shifter) which has the function of improving the resolution in photolithography.

Light rays 33 and 34 impinging on the bottom surface of the reticle and travelling a distance t, undergo a different phase shift due to the existence of the phase-shifter 3 (in practice, the reticle is arranged upside-down in the stepper). When the thickness of the phase-shifter is properly selected, two rays penetrating through the reticle can be made out of phase (phase-shift of π) with each other. This results in forming a distinct image pattern of the middle Cr layer 2' on the semiconductor substrate because the effects of the adjacent rays from both sides cancel out.

Fig. 2 shows a cross-section of another reticle structure with phase-shifters. In the same way as in Fig. 1, a pattern of light-shielding layers 2 is formed on a glass substrate 1. However, in this case a phase-shifter 3' takes the form of a groove or well formed under a window 31 between two adjacent light-shielding layers 2 and 2'. The groove is formed by subjecting the substrate 1 to a conventional anisotropic etching process such as RIE (Reactive Ion Etching), in which only the substrate surface for the groove forming area is exposed and other areas are covered with a resist layer. The function of the phase-shifter 3' is almost the same as the phase-shifter 3 of Fig. 1. However, in this case, the light 33 travelling a distance d within the substrate is given a phase difference of π from the light 34 which travels the same distance d in the groove without substrate material.

To make a reticle with phase-shifters, fine complicated patterns have to be formed on it. In the process of fabricating a reticle, defects often occur in the patterns of shield layer 2 or phase-shifters 3. In addition, even if the reticle is perfectly formed, it may happen that a small portion of the pattern needs to be modified or changed. Therefore, it is important to be able to repair or modify the pattern.

When it is found that the shield layer includes a missing portion or void portion, or an unnecessary extra portion in its pattern, before forming phase-shifters, these defects are comparatively easily repaired using a focused ion beam (hereinafter, FIB) apparatus.

Once the phase-shifters have been formed, if they include any unnecessary extra portion this can be removed using the above FIB apparatus and the reticle can be repaired. However, if the defect is a missing portion in the phase-shifter pattern, the reticle cannot be repaired easily.

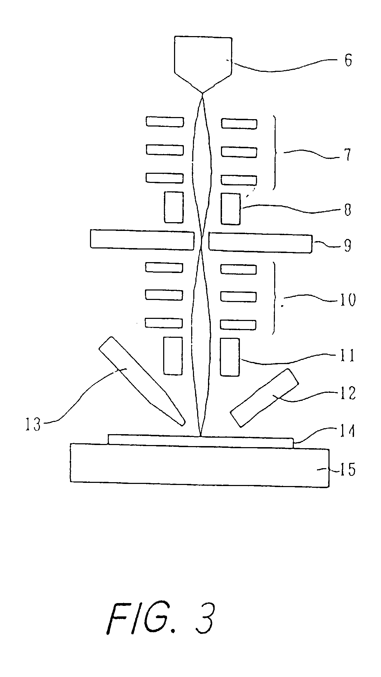

An outline of an FIB apparatus will now be given, with reference to the schematic cross-section of Fig. 3. Ions are emitted from an ion gun 6, gallium (Ga) ions often being used; these are focused by a condenser lens 7 and further on-off controlled by a blanking electrode 8 and a blanking aperture 9. An object lens 10 and a deflection lens 11 focus and project an ion beam on to an object 14 to be processed at a specified scanning position. The object can be moved by an XY-table 15. The ion beam can sputter-and-etch an object material, and a secondary ion detector 12 can detect the object material and is used to identify the ion beam position. When a gas is introduced from a gas injection gun 13, the ion beam resolves (decomposes) the gas, and the element thus obtained can be deposited on the object 14.

In order to remove an unwanted extra portion of the shield layer 2 or phase shifter 3, this portion is subjected to irradiation by the above ion beam by moving the XY-table and scanning the ion beam. However, when the phase-shifter 3 of Fig. 1 has a missing portion, or when the groove-shaped phase-shifter 3' of Fig. 2 includes an extra groove portion which should not have been removed, the processes of depositing phase-shifter material or substrate material and repairing the void portion of the phase-shifters are very difficult. The reason for this is that the thickness of phase-shifter 3 or the depth of phase-shifter 3' is too large (a few hundred nm) to bury the void portion by the FIB apparatus. If it is attempted to deposit silicon dioxide (a popular material for phase-shifters) by the FIB apparatus, the deposited phase-shifter contains gallium; since gallium-containing silicon dioxide is not transparent, it does not work as a phase-shifter.

EP-A-0 395 425 constitutes prior art for the application under Article 54(3) EPC. It discloses a reticle having a portion formed only by a substrate, a portion formed by the substrate on which is provided a phase-shifter of a first thickness, and a portion formed by the substrate on which is provided a phase shifter of a second thickness.

US-A-3 547 546 discloses a so-called zone plate used in photolithography for forming patterns such as microcircuits, and having features corresponding to those of the preamble of accompanying claims 1 and 2. The zone plate has various zones formed by regions of a transparent plate cut to different thicknesses, providing different phase shifts to transmitted light.

According to a first aspect of the invention, there is provided a reticle suitable for use in projecting a very fine pattern on a semiconductor substrate in photolithography, the reticle comprising a substrate having a light transparent area which is transparent to projection light used in the photolithography, the light transparent area comprising first, second and third transparent regions through which said projection light is to be transmitted, the first transparent region having a first surface at a first height from a bottom surface of said substrate, the second transparent region having a second surface at a second height from the bottom surface of said substrate corresponding to a top surface of the substrate, wherein said first transparent region gives the projection light transmitted through it a phase difference from the projection light transmitted through said second transparent region, and the third transparent region being selectively patterned and forming a groove in said substrate, and having a third surface at a third height from the bottom surface of said substrate, wherein the third transparent region gives the projection light transmitted through it a phase difference from the projection light transmitted through the second transparent region; characterised in that:
said first transparent region is formed by depositing and selectively patterning a phase-shift layer on said substrate; and
said third transparent region gives said projection light transmitted through it substantially the same phase as the projection light transmitted through the first transparent region, so as to repair a defective portion of said first transparent region.

According to a second aspect of the invention, there is provided a reticle suitable for use in projecting a very fine pattern on a semiconductor substrate in photolithography, the reticle comprising a substrate having a light transparent area which is transparent to projection light used in the photolithography, the light transparent area comprising first, second and third transparent regions through which said projection light is to be transmitted, the first transparent region having a first surface at a first height from a bottom surface of said substrate, the second transparent region being selectively patterned and forming a first groove in said substrate and having a second surface at a second height from the bottom surface of said substrate, wherein said first transparent region gives the projection light transmitted through it a phase difference from the projection light transmitted through said second transparent region, and the third transparent region being selectively patterned and forming a second groove, and having a third surface at a third height from the bottom surface of said substrate, wherein the third transparent region gives the projection light transmitted through it a phase difference from the projection light transmitted through the second transparent region; characterised in that:
said third transparent region gives said projection light transmitted through it substantially the same phase as the projection light transmitted through the first transparent region, so as to repair a defective portion of said first transparent region.

An embodiment of the present invention may thus provide a reticle with phase-shifters which can easily accommodate a small pattern change after completion of reticle fabrication, and which can allow the repair of any pattern defect.

The present invention also embraces methods of fabricating the above-defined reticles.

In this specification, the term "light" refers to projection light used in photolithography. The terms "light" and "photolithography" in this specification need not be restricted to visible light and can also embrace other forms of radiation and lithography.

### BRIEF DESCRIPTION OF THE DRAWINGS

Figure 1 shows a cross sectional view of a reticle with phase-shifters, in which a deposited (hereinafter called a positive type) phase-shifter is formed on a reticle substrate,
Figure 2 shows a cross sectional view of a reticle with phase-shifters, in which a grooved (hereinafter called a negative type) phase-shifter is formed in a reticle substrate,
Figure 3 shows a schematic cross section of a focused ion beam (FIB) apparatus used in fabricating a reticle with phase-shifters of the present invention,
Figures 4(a) and 4(b) show a top view of a shield layer and a phase-shifter formed thereon on a reticle substrate, wherein Figure 4(a) shows a case that correct pattern is formed, and Figure 4(b) shows that the shield layer has defects,
Figures 5(a) to 5(d) show a cross sectional view of the reticle with phase-shifters during the repair process in a sequential steps, in which the reticle having defects such as in Figure 4(b) is repaired (first embodiment),
Figures 6(a) and 6(b) show a cross sectional view of a reticle with positive type phase-shifters, and the reticle having a defect is shown in Figure 6(a) and the reticle repaired is shown in Figure 6(b) (second embodiment),
Figures 7(a) and 7(b) show a cross sectional view of an enlarged groove for explaining the repairing method of the groove in accordance with the present invention,
Figures 8(a) and 8(b) show a cross sectional view of a reticle with negative type phase-shifters, and the reticle having a defect is shown in Figure 8(a) and the reticle repaired is shown in Figure 8(b) (third embodiment),
Figure 9(a) and 9(b) show a cross sectional view of a reticle with positive type phase-shifters in which phase-shifters are formed on a substrate and shield layer is deposited thereon, and the reticle having a defect is shown in Figure 9(a) and the reticle repaired is shown in Figure 9(b) (fourth embodiment), and
Figure 10 shows a cross sectional view of a reticle with positive and negative type phase-shifters, in which both types of phase-shifters are formed, and no shield layer is used (not in accordance with the invention).

Same or like reference numerals designate same or corresponding parts throughout the drawings.

### (1) First Embodiment

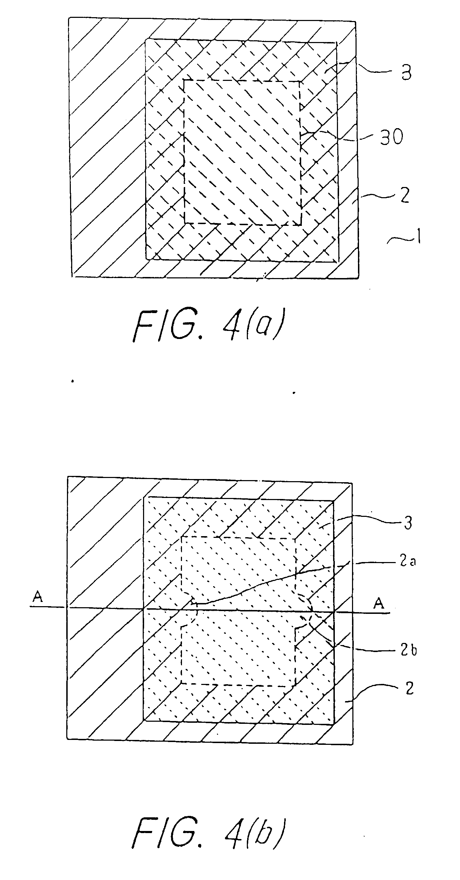

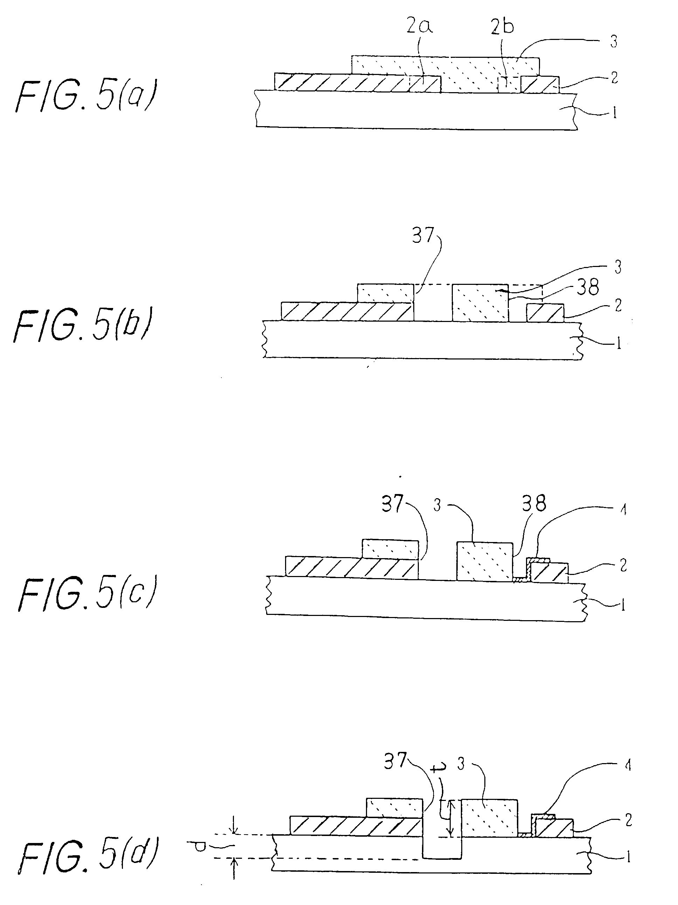

Details of a first embodiment of the the present invention are disclosed referring to Figures 4(a) and 4(b), and Figures 5(a) through 5(d).

Figure 4(a) shows a portion of a top view of a reticle with phase-shifters having a correct pattern of a shield layer 2 which has a rectangular outline and a rectangular opening 30. The shield layer 2 is formed by depositing Cr layer having a thickness of 60 to 80 nm which is subsequently patterned by a conventional photolithography technique. The first embodiment utilizes a positive type phase-shifter 3, therefore, the phase-shifter 3 is formed by depositing a silicon dioxide (SiO₂) layer and thereafter the SiO₂ layer is patterned. A thickness of the phase-shifter 3 is about 390 nm when i-line rays are used in the stepper. The thickness of the phase-shifter 3 is much larger than that of the shield layer 2.

Figure 4(b) shows the similar top view of the reticle with phase-shifters as Figure 4(a), however in this case, the shield layer 2 has defective portions 2a and 2b. The portion 2a is an extra protrusion and the portion 2b is a missing portion, both being transformed from the normally straight line periphery. The shapes of defects in the figure are quite schematic and these defects can be easily repaired if the phase-shifter 3 is not formed on the shield layer 2.

After formation of the phase-shifter 3, defective portions are often required to be repaired such that the extra portion 2a is removed and the missing portion 2b is supplemented. A method of repairing defective portions is next explained referring to Figures 5(a) through 5(d).

Figures 5(a) to 5(d) show a cross sectional view at sequential steps of the repair along line A-A in Figure 4(b). Figure 5(a) shows a cross section at an initial stage before the repair processes, in which defective portions 2a and 2b in the shield layer 2 are shown by dashed lines. First as shown in Figure 5(b), the portion of the phase-shifter 3 lying on the extra portion 2a and the portion 2a of the shield layer are removed by a sputter-and-etch method by the previously explained FIB apparatus of Figure 3 forming an opening 37, and thereafter the phase-shifter portion burying the void portion 2b and lying thereon and the neighboring portion on the shield layer 2 are removed using the same apparatus forming an opening 38.

Next, injecting a tungsten-hexacarbonyl [W(CO)₆] gas through a gas injection gun 13 in the FIB apparatus of Figure 3 into the opening 38, a tungsten layer 4 is deposited as shown in Figure 5(c).

Next, the exposed surface of the reticle substrate 1 in the opening 37 is subjected to a sputter-and-etch process by the FIB apparatus, resulting in forming a groove having a depth d shown in Figure 5(d).

A necessary depth amount d is given by the following equations;$\text{(nd/λ)-(d/λ) = (1+2m)/2,}$ or$\text{d = λ(1+2m)/2(n-1),}$ where n is a refractive index of the substrate material, λ is a wavelength of light used in the stepper, and m is an integer such as 0, 1, 2, .... .

The above equations are given for the depth of the groove type phase-shifter (negative type phase-shifter), however, the similar equations are given for a thickness t of the deposited phase-shifter (positive type phase-shifter), in which depth d is replaced by thickness t and refractive index n is used for the material of the deposited phase-shifter.

By calculation, the depth d is given as about 3900 angstroms for quartz or glass substrate, which is substantially equal to a thickness t of the positive type deposited SiO₂ phase-shifter.

However, thickness t and depth d of the phase-shifters of the present invention are not restricted to the given amount by the equation. Different amounts of thickness or depth for phase-shifters have enough effect of improving the formed pattern on an object.

### (2) Second Embodiment

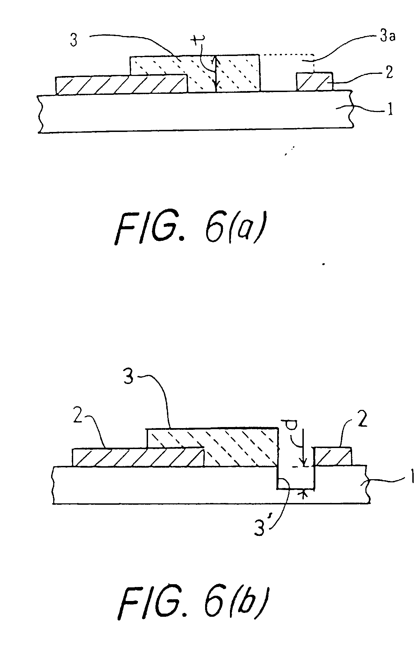

Next, a second embodiment of the present invention is explained referring to Figures 6(a) and 6(b). Figure 6(a) is a cross sectional view of a reticle with phase-shifters of a positive type, in which a phase-shifter 3 includes a defect of missing portion 3a. A thickness t of the phase shifter 3 is given by the above modified calculation using equation (1), and in the actual embodiment of Figure 6(a), since SiO₂ layer is used as the phase-shifter 3, and therefore in this case, the thickness t is about 3900 angstroms.

In order to repair the defect portion 3a, it is difficult to deposit a SiO₂ layer by use of the FIB apparatus, because the required thickness is too large and the deposited layer is not transparent. In accordance with the present invention, the defect portion 3a is repaired by forming a groove having a depth d, which means a negative type phase shifter 3', into the reticle substrate 1 as shown in Figure 6(b). The depth d is given by the previous equation (1). The negative type phase-shifter 3' can be formed by a sputter-and-etch process utilizing the FIB apparatus.

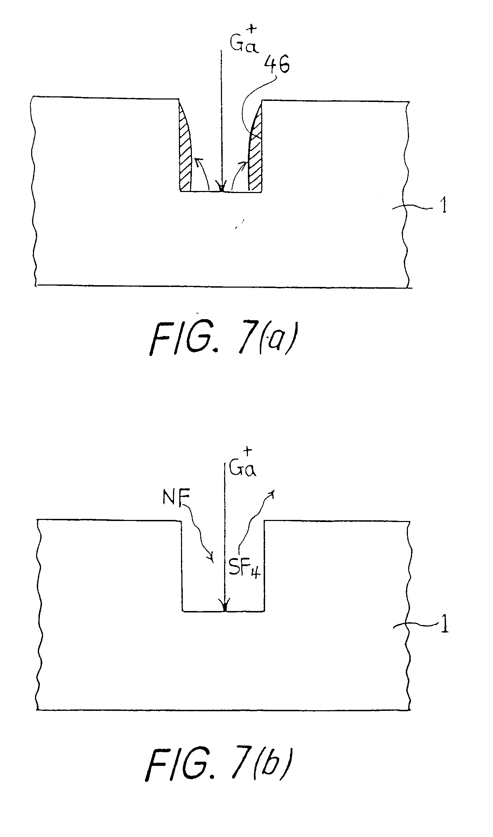

In forming the groove, it is preferable that the sidewall and the bottom surface of the groove are respectively vertical and parallel to the substrate surface as much as possible. Figure 7(a) shows an enlarged cross sectional view of the grooved portion 46 only, where the groove shows rather a sharp trench shape having, for example, a width of about 0.2 to 0.4 µm and a depth of about 0.39 µm. When Ga ions are irradiated onto the groove forming region on the substrate, the substrate material such as quartz or glass is sputtered from the substrate and sputtered material again deposits on the sidewall of the groove 46 as shown in Figure 7(a).

In the embodiment as shown in Figure 7(b), it is found that any gas selected among the group of a carbon tetrafluoride gas (CF₄), a nitrogen fluoride gas (NF₃), a fluorine gas (F₂), a sulfur fluoride gas (SF₆), a hydrogen fluoride gas (HF), and a chlorine gas (Cl₂), is preferably injected from the gas injection gun 13 in the FIB apparatus. The object therefor is to remove the substrate material in a volatile silicon compound form such as silicon fluoride (SiF₄). This method prevents the substrate material from depositing on the sidewall of the groove.

### (3) Third Embodiment

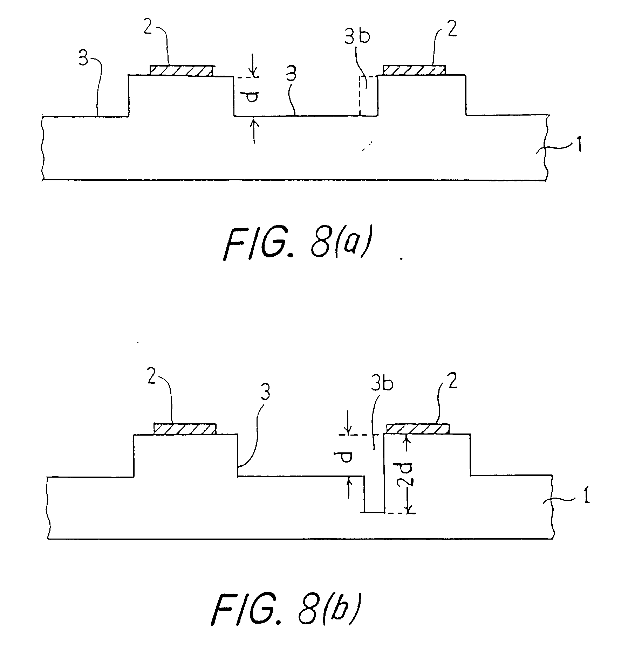

A third embodiment of the present invention is explained referring to Figures 8(a) and 8(b). Figure 8(a) shows a cross sectional view of a reticle with phase-shifters, in which negative type phase-shifters 3 are formed in a reticle substrate 1 between shield layers 2. The phase-shifter 3 has a defective portion 3b, which should not be removed in case of forming a correct phase-shifter pattern.

Since processes of depositing the substrate material (glass) onto the defect void portion 3b and burying the void portion, are difficult because of a large depth and transparency thereof, it is found that, when an additional negative type phase-shifter is added under the void portion 3b, it has the same effect as that the void portion is buried with deposited material. The depth of the defect portion is increased to 2d, which is twice the normal phase-shifter depth d. The depth 2d means that light traveling the distance 2d receives a phase-shift of one full wavelength (2π phase-shift), and therefore, it shows the same characteristic as if no phase-shifter is formed at the void portion 3b.

### (4) Fourth Embodiment

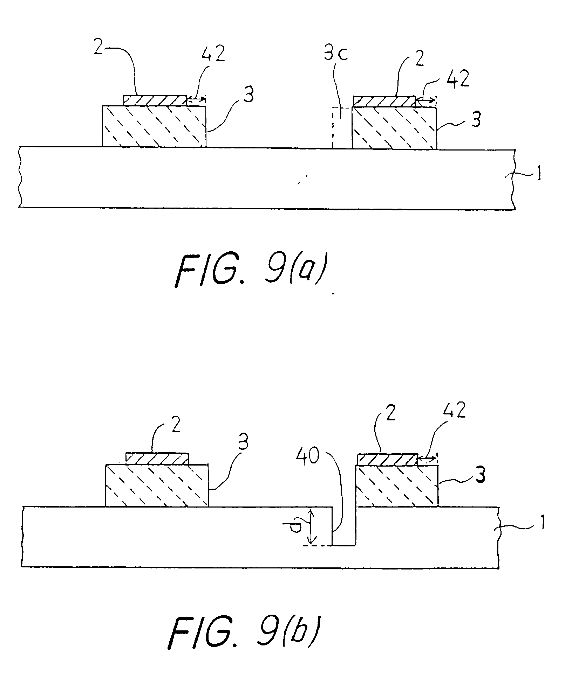

A fourth embodiment of the present invention is explained referring to Figures 9(a) and 9(b). Figure 9(a) shows a cross sectional view of a reticle with phase-shifters, in which positive type phase-shifters 3 are formed on a reticle substrate 1, and a shield layer 2 of (Cr) is deposited thereon. The phase-shifter 3 has a shoulder portion 42 on both sides of the shield layer 2, and one shoulder portion has a defective portion 3c, which should not be taken away when a correct phase-shifter pattern is formed.

Since processes of depositing the shifter material such as SiO₂ onto the defect void portion 3c and burying the void portion, are difficult because of a large thickness and transparency of the deposited layer, it is found that, when a negative type phase-shifter, namely, a groove 40 is formed under the void portion 3c, it has the same effect as that the void portion is repaired with the deposited phase-shifter. Since the depth of the groove to be formed is d, light traveling through the groove of distance d receives a phase-shift of π which is the same as that caused by the phase-shifter 3.

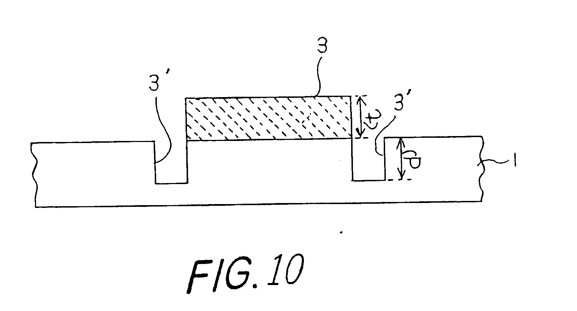

Throughout the embodiments described above, all reticles include a patterned shield layer. However, a reticle of the present invention is not limited to these type, the present invention may be applied to a reticle structure without a shield layer. Figure 10 shows a cross sectional view of a reticle with phase-shifters, in which positive and negative type phase-shifters are formed and no shield layer is used, by way of background explanation.

A positive type phase-shifter 3 is formed on a reticle substrate 1 and a negative type phase-shifter 3' is formed on both sides of the positive type phase-shifter 3. Although this reticle is not in accordance with the invention, it illustrates that a shield layer is not essential.

The present invention may be embodied in other specific forms without departing from the spirit or essential characteristics thereof. The presently disclosed embodiments are, therefore, to be considered in all respects as illustrative and not restrictive, the scope of the invention being indicated by the appended claims, rather than the foregoing description, and all changes which come within the meaning of the claims are, therefore, to be embraced therein.

## Claims

1. A reticle suitable for use in projecting a very fine pattern on a semiconductor substrate in photolithography, the reticle comprising a substrate (1) having a light transparent area which is transparent to projection light used in the photolithography, the light transparent area comprising first, second and third transparent regions through which said projection light is to be transmitted, the first transparent region (3) having a first surface at a first height from a bottom surface of said substrate (1), the second transparent region having a second surface at a second height from the bottom surface of said substrate corresponding to a top surface of the substrate (1), wherein said first transparent region gives the projection light transmitted through it a phase difference from the projection light transmitted through said second transparent region, and the third transparent region being selectively patterned and forming a groove (37, 3', 40) in said substrate, and having a third surface at a third height from the bottom surface of said substrate (1), wherein the third transparent region gives the projection light transmitted through it a phase difference from the projection light transmitted through the second transparent region; characterised in that:
said first transparent region (3) is formed by depositing and selectively patterning a phase-shift layer on said substrate (1); and
said third transparent region gives said projection light transmitted through it substantially the same phase as the projection light transmitted through the first transparent region, so as to repair a defective portion of said first transparent region (3).

2. A reticle suitable for use in projecting a very fine pattern on a semiconductor substrate in photolithography, the reticle comprising a substrate (1) having a light transparent area which is transparent to projection light used in the photolithography, the light transparent area comprising first, second and third transparent regions through which said projection light is to be transmitted, the first transparent region (3) having a first surface at a first height from a bottom surface of said substrate (1), the second transparent region being selectively patterned and forming a first groove in said substrate and having a second surface at a second height from the bottom surface of said substrate, wherein said first transparent region (3) gives the projection light transmitted through it a phase difference from the projection light transmitted through said second transparent region, and the third transparent region being selectively patterned and forming a second groove (3b), and having a third surface at a third height from the bottom surface of said substrate (1), wherein the third transparent region gives the projection light transmitted through it a phase difference from the projection light transmitted through the second transparent region; characterised in that:
said third transparent region gives said projection light transmitted through it substantially the same phase as the projection light transmitted through the first transparent region, so as to repair a defective portion of said first transparent region (3).

3. A reticle as recited in claim 1 or 2, wherein said phase difference between said projection light transmitted through said first and second transparent regions is substantially equal to a half wavelength of said projection light.

4. A reticle as recited in claim 1, wherein said first transparent region and said third transparent region are arranged side by side so as to have a common edge.

5. A reticle as recited in any preceding claim, wherein said substrate (1) is made of quartz or glass.

6. A reticle as recited in claim 1, wherein said phase-shift layer (3) is of silicon dioxide (SiO₂).

7. A reticle as recited in any preceding claim, further comprising a light shield layer (2) which is formed on the substrate (1) and patterned to define said light transparent area.

8. A reticle as recited in claim 7, wherein said shield layer (2) comprises chromium.

9. A method of fabricating the reticle as claimed in claim 1, comprising the steps of:
(a) depositing said phase-shift layer (3) on said substrate (1), the thickness of the phase-shift layer being selected so as to produce a phase difference between projection light transmitted through said substrate without said phase-shift layer and projection light transmitted through both said substrate and said phase-shift layer,
(b) selectively removing said phase-shift layer (3), thereby defining said first transparent region in an area having both said substrate (1) and said phase-shift layer, and said second transparent region in an area having said substrate only, and
(c) selectively removing said substrate (1) to a certain depth so as to form said groove (37, 3', 40) in said substrate, thereby defining said third transparent region in the area of said groove, wherein projection light transmitted through said third transparent region is given substantially the same phase as projection light transmitted through said first transparent region, said third transparent region being formed in an area corresponding to the defective portion of said first transparent region.

10. A method of fabricating the reticle as claimed in claim 2, comprising the steps of:
(a) forming said first groove (3) in said substrate, thereby defining said first transparent region in the substrate area outside said first groove and said second transparent region in the area of said first groove, the depth of the first groove being selected so as to produce a phase difference between projection light transmitted through said first transparent region and projection light transmitted through said second transparent region, and
(b) forming said second groove (3b) in said second transparent region, thereby defining said third transparent region in the area of said second groove, the depth of the second groove being selected such that projection light transmitted through said third region is given the same phase as projection light transmitted through said first transparent region; said third transparent region being formed in an area corresponding to the defective portion of said first transparent region.

11. A method as recited in claim 9, wherein said step (c) further comprises the substeps of:
placing said reticle into a focused ion beam apparatus, the apparatus being provided with a gas injection gun,
injecting a gas comprising halogen on to said defective portion on the substrate, and
irradiating an ion beam on the area of said defective portion to remove some material in that area thereby forming said third transparent region.

12. A method as recited in claim 11, wherein said halogen comprising gas is one selected from the group of carbon tetrafluoride gas (CF₄), nitrogen fluoride gas (NF₃), fluorine gas (F₂), sulphur fluoride gas (SF₆), hydrogen fluoride gas (HF), and chlorine gas (Cl₂).

13. A method as recited in claim 10, wherein said step (b) further comprises the substeps of:
placing said reticle into a focused ion beam apparatus, the apparatus being provided with a gas injection gun,
injecting a gas comprising halogen on to said defective portion of the substrate, and
irradiating an ion beam on the area of said defective portion to remove some of the substrate in that area, thereby forming said second groove.

14. A method as recited in claim 13, wherein said halogen comprising gas is selected from the group of carbon tetrafluoride gas (C₄), nitrogen fluoride gas (NF₃), fluorine gas (F₂), sulphur fluoride gas (SF₆), hydrogen fluoride gas (HF), and chlorine gas (Cl₂).

## Patentansprüche

1. Zwischenmaske, die für die Verwendung bei der Projizierung eines sehr feinen Musters auf ein Halbleitersubstrat in der Photolithographie geeignet ist, wobei die Zwischenmaske ein Substrat (1) umfaßt, welches einen lichtdurchlässigen Bereich aufweist, der transparent ist gegenüber Projektionslicht, welches in der Photolithographie verwendet wird, wobei der lichtdurchlässige Bereich eine erste, eine zweite und eine dritte transparente Zone aufweist, durch die das Projektionslicht zu übertragen ist, die erste transparente Zone (3) eine erste Oberfläche bei einer ersten Höhe von einer Bodenfläche des Substrats (1) aus hat, die zweite transparente Zone eine zweite Oberfläche bei einer zweiten Höhe von der Bodenfläche des Substrats aus hat, die einer oberen Fläche des Substrats (1) entspricht, wobei die erste transparente Zone dem Projektionslicht, welches dort hindurch übertragen wird, eine Phasendifferenz von dem Projektionslicht erteilt, welches durch die zweite transparente Zone hindurch geleitet wird, und wobei die dritte transparente Zone selektiv in ein Muster gebracht wird und.in dem Substrat eine Nut (37, 3', 40) ausgebildet wird, und eine dritte Fläche bei einer dritten Höhe von der Bodenfläche des Substrats (1) aus besitzt, wobei die dritte transparente Zone dem Projektionslicht, welches durch diese hindurch übertragen wird, eine Phasendifferenz gegenüber dem Projektionslicht erteilt, welches durch die zweite transparente Zone übertragen wird, dadurch gekennzeichnet, daß:
die erste transparente Zone (3) durch Niederschlagen und selektive Musterausbildung einer Phasenschieberschicht auf dem Substrat (1) gebildet ist; und
die dritte transparente Zone dem Projektionslicht, welches durch diese übertragen wird, im wesentlichen die gleiche Phase erteilt, wie dem Projektionslicht, welches durch die erste transparente Zone übertragen wird, um dadurch einen defekten Abschnitt der ersten transparente Zone (3) zu reparieren.

2. Zwischenmaske, die für die Verwendung bei der Projektion eines sehr feinen Musters auf ein Halbleitersubstrat in der Photolithographie verwendet werden kann, wobei die Zwischenmaske ein Substrat (1) umfaßt, welches einen lichtdurchlässigen Bereich aufweist, der transparent ist gegenüber Projektionslicht, welches in der Photolithographie verwendet wird, wobei der lichtdurchlässige Bereich eine erste, eine zweite und eine dritte transparente Zone umfaßt, durch die das Projektionslicht zu übertragen ist, die erste transparente Zone (3) eine erste Oberfläche bei einer ersten Höhe von einer Bodenfläche des Substrats (1) aus besitzt, die zweite transparente Zone selektiv in ein Muster gebracht ist und eine erste Nut in dem Substrat bildet, und eine zweite Oberfläche bei einer zweiten Höhe von der Bodenfläche des Substrats aus besitzt, wobei die erste transparente Zone (3) dem Projektionslicht, welches dort hindurch übertragen wird, eine Phasendifferenz gegenüber dem Projektionslicht erteilt, welches durch die zweite transparente Zone übertragen wird, und wobei die dritte transparente Zone selektiv in ein Muster gebracht ist und eine zweite Nut (3b) bildet, und eine dritte Oberfläche bei einer dritten Höhe von der Bodenfläche des Substrats (1) aus besitzt, wobei die dritte transparente Zone dem Projektionslicht, welches durch diese hindurch übertragen wird, eine Phasendifferenz gegenüber dem Projektionslicht erteilt, welches durch die zweite transparente Zone übertragen wird, dadurch gekennzeichnet, daß:
die dritte transparente Zone dem Projektionslicht, welches durch diese übertragen wird, im wesentlichen die gleiche Phase wie dem Projektionslicht erteilt, welches durch die erste transparente Zone übertragen wird, um einen defekten Abschnitt der ersten transparenten Zone (3) zu reparieren.

3. Zwischenmaske nach Anspruch 1 oder 2, bei der die Phasendifferenz zwischen dem Projektionslicht, welches durch die erste und die zweite transparente Zone übertragen wird, im wesentlichen gleich ist einer halben Wellenlänge des Projektionslichtes.

4. Zwischenmaske nach Anspruch 1, bei der die erste transparente Zone und die dritte transparente Zone Seite an Seite angeordnet sind, so daß sie eine gemeinsame Kante haben.

5. Zwischenmaske nach irgendeinem der vorhergehenden Ansprüche, bei der das Substrat (1) aus Quarz oder Glas hergestellt ist.

6. Zwischenmaske nach Anspruch 1, bei der die Phasenschieberschicht (3) aus Siliziumdioxid (SiO2) besteht.

7. Zwischenmaske nach irgendeinem der vorhergehenden Ansprüche, ferner mit einer Lichtabschirmschicht (2), die auf dem Substrat (1) ausgebildet ist und derart in ein Muster gestaltet ist, daß der lichtdurchlässige Bereich festgelegt ist.

8. Zwischenmaske nach Anspruch 7, bei der die Abschirmschicht (2) Chrom aufweist.

9. Verfahren zur Herstellung einer Zwischenmaske nach Anspruch 1, mit den folgenden Schritten:
(a) Niederschlagen einer Phasenschieberschicht (3) auf dem Substrat (1), wobei die Dicke der Phasenschieberschicht so ausgewählt wird, daß eine Phasendifferenz zwischen dem Projektionslicht, welches durch das Substrat ohne die Phasenschieberschicht übertragen wird, und dem Projektionslicht, welches durch das Substrat als auch die Phasenschieber übertragen wird, erzeugt wird,
(b) selektives Entfernen der Phasenschieberschicht (3), um dadurch die erste transparente Zone in einem Bereich festzulegen, der sowohl das Substrat (1) als auch die Phasenschieberschicht aufweist, und um die zweite transparente Zone in einem Bereich festzulegen, der lediglich das Substrat enthält, und
(c) selektives Entfernen des Substrats (1) bis zu einer bestimmten Tiefe, um eine Nut (37, 3', 40) in dem Substrat auszubilden, um dadurch die dritte transparente Zone in dem Bereich der Nut festzulegen, wobei dem Projektionslicht, welches durch die dritte transparente Zone übertragen wird, im wesentlichen die gleiche Phase erteilt wird, wie dem Projektionslicht, welches durch die erste transparente Zone übertragen wird, wobei die dritte transparente Zone in einem Bereich ausgebildet wird, der dem defekten Abschnitt der ersten transparenten Zone entspricht.

10. Verfahren zur Herstellung einer Zwischenmaske nach Anspruch 2, mit den folgenden Schritten:
(a) Ausbilden der ersten Nut (3) in dem Substrat, wodurch die erste transparente Zone in dem Substratbereich außerhalb der ersten Nut festgelegt wird und die zweite transparente Zone in dem Bereich der ersten Nut festgelegt wird, wobei die Tiefe der ersten Nut so gewählt wird, daß eine Phasendifferenz zwischen dem Projektionslicht, welches durch die erste transparente Zone übertragen wird, und dem Projektionslicht, welches durch die zweite transparente Zone übertragen wird, erzeugt wird, und
(b) Ausbilden der zweiten Nut (3b) in der zweiten transparenten Zone, um dadurch die dritte transparente Zone in dem Bereich der zweiten Nut festzulegen, wobei die Tiefe der zweiten Nut so gewählt wird, daß dem Projektionslicht, welches durch die dritte Zone übertragen wird, die gleiche Phase wie dem Projektionslicht erteilt wird, welches durch die erste transparente Zone übertragen wird; wobei die dritte transparente Zone in einem Bereich ausgebildet wird, der dem defekten Abschnitt der ersten transparente Zone entspricht.

11. Verfahren nach Anspruch 9, bei dem der Schritt (c) ferner die folgenden Unterschritte umfaßt:
Plazieren der Zwischenmaske auf einem Gerät, welches einen fokussierten Ionenstrahl erzeugt, wobei das Gerät mit einer Gasinjektionskanone ausgestattet ist,
Injizieren eines Gases, welches Halogen enthält, auf den defekten Abschnitt auf dem Substrat, und
Aufstrahlen eines Ionenstrahls auf den Bereich des defekten Abschnitts, um etwas Material in diesem Bereich zu entfernen, so daß die dritte transparente Zone gebildet wird.

12. Verfahren nach Anspruch 11, bei dem das Gas, welches Halogen enthält, ausgewählt ist aus einer Gruppe aus Kohlenstoff-Tetrafluorgas (CF₄), Stickstoff-Fluorgas (NF₃), Fluorgas (F₂), Schwefel-Fluorgas (SF₆), Wasserstoff-Fluorgas (HF) und Chlorgas (Cl₂).

13. Verfahren nach Anspruch 10, bei dem der Schritt (b) ferner die folgenden Unterschritte aufweist:
Plazieren der Zwischenmaske auf einem Gerät, welches einen fokussierten Ionenstrahl erzeugt, wobei das Gerät mit einer Gasinjektionskanone ausgestattet ist,
Injizieren eines Gases, welches Halogen enthält, auf den defekten Abschnitt des Substrats, und
Aufstrahlung eines Ionenstrahls auf den Bereich des defekten Abschnitts, um etwas von dem Substrat in diesem Bereich zu entfernen, um dadurch die zweite Nut auszubilden.

14. Verfahren nach Anspruch 13, bei dem das Gas, welches das Halogen enthält, ausgewählt ist aus der Gruppe bestehend aus Kohlenstoff-Tetrafluorgas (CF₄), Stickstoff-Fluorgas (NF₃), Fluorgas (F₂), Schwefel-Fluorgas (SF₆), Wasserstoff-Fluorgas (HF) und Chlorgas (Cl₂).

## Revendications

1. Réticule convenant à une utilisation pour projeter un motif très fin sur un substrat de semiconducteur en photolithographie, le réticule comprenant un substrat (1) comportant une zone transparente à la lumière qui est transparente à la lumière de projection utilisée dans la photolithographie, la zone transparente à la lumière comprenant des première, seconde et troisième régions transparentes au travers desquelles ladite lumière de projection doit être transmise, la première région transparente (3) comportant une première surface à une première hauteur par rapport à une surface inférieure dudit substrat (1), la seconde région transparente comportant une seconde surface à une seconde hauteur par rapport à la surface inférieure dudit substrat correspondant à une surface supérieure du substrat (1), dans lequel ladite première région transparente communique à la lumière de projection transmise au travers de celle-ci une différence de phase par rapport à la lumière de projection transmise au travers de ladite seconde région transparente, et la troisième région transparente étant sélectivement mise en motif en formant une rainure (37, 3', 40) dans ledit substrat, et comportant une troisième surface à une troisième hauteur par rapport à la surface inférieure dudit substrat (1), dans laquelle la troisième région transparente communique à la lumière de projection transmise au travers de celle-ci une différence de phase par rapport à la lumière de projection transmise au travers de la seconde région transparente, caractérisé en ce que :
ladite première région transparente (3) est formée en déposant et en mettant en motif sélectivement une couche de déphasage sur ledit substrat (1), et
ladite troisième région transparente communique à ladite lumière de projection transmise au travers de celle-ci pratiquement la même phase que la lumière de projection transmise au travers de la première région transparente, de façon à réparer une partie défectueuse de ladite première région transparente (3).

2. Réticule convenant à une utilisation pour projeter un motif très fin sur un substrat de semiconducteur en photolithographie, le réticule comprenant un substrat (1) comportant une zone transparente à la lumière qui est transparente à la lumière de projection utilisée dans la photolithographie, la zone transparente à la lumière comprenant des première, seconde et troisième régions transparentes au travers desquelles ladite lumière de projection doit être transmise, la première région transparente (3) comportant une première surface à une première hauteur par rapport à une surface inférieure dudit substrat (1), la seconde région transparente étant sélectivement mise en motif et formant une première rainure dans ledit substrat et comportant une seconde surface à une seconde hauteur par rapport à la surface inférieure dudit substrat, dans lequel ladite première région transparente (3) communique à la lumière de projection transmise au travers de celle-ci une différence de phase par rapport à la lumière de projection transmise au travers de ladite seconde région transparente, et la troisième région transparente étant sélectivement mise en motif et formant une seconde rainure (3b), et comportant une troisième surface à une troisième hauteur par rapport à la surface inférieure dudit substrat (1), dans lequel la troisième région transparente communique à la lumière de projection transmise au travers de celle-ci une différence de phase par rapport à la lumière de projection transmise au travers de la seconde région transparente, caractérisé en ce que :
la troisième région transparente communique à ladite lumière de projection transmise au travers de celle-ci pratiquement la même phase que la lumière de projection transmise au travers de la première région transparente, de façon à réparer une partie défectueuse de ladite première région transparente (3).

3. Réticule selon la revendication 1 ou 2, dans lequel ladite différence de phase entre ladite lumière de projection transmise au travers desdites première et seconde régions transparentes est pratiquement égale à une demi-longueur d'onde de ladite lumière de projection.

4. Réticule selon la revendication 1, dans lequel ladite première région transparente et ladite troisième région transparente sont disposées côte à côte de façon à présenter un bord commun.

5. Réticule selon l'une quelconque des revendications précédentes, dans lequel ledit substrat (1) est fait de quartz ou de verre.

6. Réticule selon la revendication 1, dans lequel ladite couche de déphasage (3) est faite de dioxyde de silicium (SiO₂).

7. Réticule selon l'une quelconque des revendications précédentes, comprenant en outre une couche de masque de lumière (2) qui est formée sur le substrat (1) et mise en motif afin de définir ladite zone transparente à la lumière.

8. Réticule selon la revendication 7, dans lequel ladite couche de masque (2) comprend du chrome.

9. Procédé de fabrication du réticule selon la revendication 1, comprenant les étapes consistant à :
(a) déposer ladite couche de déphasage (3) sur ledit substrat (1), l'épaisseur de la couche de déphasage étant choisie de façon à produire une différence de phase entre la lumière de projection transmise au travers dudit substrat sans ladite couche de déphasage et la lumière de projection transmise au travers, à la fois dudit substrat et de ladite couche de déphasage,
(b) éliminer sélectivement ladite couche de déphasage (3), en définissant ainsi ladite première région transparente dans une zone comportant à la fois ledit substrat (1) et ladite couche de déphasage, et ladite seconde région transparente dans une zone comportant uniquement ledit substrat, et
(c) éliminer sélectivement ledit substrat (1) jusqu'à une certaine profondeur de façon à former ladite rainure (37, 3', 40) dans ledit substrat, en définissant ainsi ladite troisième région transparente dans la zone de ladite rainure, dans lequel la lumière de projection transmise au travers de ladite troisième région transparente reçoit pratiquement la même phase que la lumière de projection transmise au travers de ladite première région transparente, ladite troisième région transparente étant formée dans une zone correspondant à la partie défectueuse de ladite première région transparente.

10. Procédé de fabrication du réticule selon la revendication 2, comprenant les étapes consistant à :
(a) former ladite première rainure (3) dans ledit substrat, en définissant ainsi ladite première région transparente dans la zone du substrat à l'extérieur de ladite première rainure et ladite seconde région transparente dans la zone de ladite première rainure, la profondeur de la première rainure étant choisie de façon à produire une différence de phase entre la lumière de projection transmise au travers de ladite première région transparente et la lumière de projection transmise au travers de ladite seconde région transparente, et
(b) former ladite seconde rainure (3b) dans ladite seconde région transparente, en définissant ainsi ladite troisième région transparente dans la zone de ladite seconde rainure, la profondeur de la seconde rainure étant choisie de façon à ce que la lumière de projection transmise au travers de ladite troisième région reçoive la même phase que la lumière de projection transmise au travers de ladite première région transparente, ladite troisième région transparente étant formée dans une zone correspondant à la partie défectueuse de ladite première région transparente.

11. Procédé selon la revendication 9, dans lequel ladite étape (c) comprend en outre les sous-étapes consistant à :
placer ledit réticule dans un appareil à faisceau d'ions focalisé, l'appareil étant muni d'un pistolet d'injection de gaz,
injecter un gaz comprenant un halogène sur ladite partie défectueuse du substrat, et
faire rayonner un faisceau d'ions sur la zone de ladite partie défectueuse afin d'éliminer certains matériaux dans cette zone en formant ainsi ladite troisième région transparente.

12. Procédé selon la revendication 11, dans lequel ledit gaz comprenant un halogène est un gaz sélectionné à partir du groupe du gaz de tétrafluorure de carbone (CF₄), du gaz de fluorure d'azote (NF₃), du gaz de fluor (F₂), du gaz de fluorure de soufre (SF₆), du gaz de fluorure d'hydrogène (HF), et du gaz de chlore (Cl₂).

13. Procédé selon la revendication 10, dans lequel ladite étape (b) comprend en outre les sous-étapes consistant à :
placer ledit réticule dans un appareil à faisceau d'ions focalisé, l'appareil étant muni d'un pistolet d'injection de gaz,
injecter un gaz comprenant un halogène sur ladite partie défectueuse du substrat, et
faire rayonner un faisceau d'ions sur la zone de ladite partie défectueuse afin d'éliminer une partie du substrat dans cette zone, en formant ainsi ladite seconde rainure.

14. Procédé selon la revendication 13, dans lequel ledit gaz comprenant un halogène est sélectionné à partir du groupe du gaz de tétrafluorure de carbone (CF₄), du gaz de fluorure d'azote (NF₃), du gaz de fluor (F₂), du gaz de fluorure de soufre (SF₆), du gaz de fluorure d'hydrogène (HF), et du gaz de chlore (Cl₂).
